# EUROPÄISCHE PATENTANMELDUNG

(11) **EP 0 768 815 A1**
(43) Veröffentlichungstag der Anmeldung: **16.04.1997**
(21) Anmeldenummer: 96116003.3
(22) Anmeldetag: 05.10.1996
(51) Int. Cl.: H05K 3/40, H05K 3/20

(54) **Verfahren zur Herstellung elektrischer Schaltungen mit einer Leiterplatte**

(30) Priorität: 12.10.1995 DE 29516161 U
(71) Anmelder: STOCKO Metallwarenfabriken Henkels und Sohn GmbH & Co, 42327 Wuppertal (DE)
(72) Erfinder: Karacora, Sami, Dipl.-Ing., D-42107 Wuppertal (DE)
(74) Vertreter: Stenger, Watzke & Ring Patentanwälte

(57) **Zusammenfassung**

Die Erfindung betrifft ein Verfahren zur Herstellung elektrischer Schaltungen mit einer Leiterplatte und auf einem Plattengrundkörper (2) befestigten Leiterbahnen (3) mit mindestens einer Kontaktierstelle (5) zur Aufnahme mindestens eines elektrischen und/oder elektronischen Bauelementes. Um das Befestigen der Leiterbahnen (3) auf dem Plattengrundkörper (2) sowie das Bestücken der Leiterbahnen mit den Bauelementen (4) vollautomatisch und kostengünstig durchführen zu können, weist das Verfahren folgende Verfahrensschritte auf:
a) Ausstanzen der einstückigen Leiterbahnen (3) aus einem ebenen Blechstanzteil, wobei die einzelnen Leiterbahnen (3) ein zusammenhängendes Band bildend über einen schmalen Rahmen miteinander verbunden sind und die Kontaktierstellen (5) als Klemmverbindungen in der Form von Schneidklemmverbindungen (6a) und/oder Gabelfederverbindungen (6b) ausgebildet sind;
b) Ausstanzen der einzelnen einstückigen Leiterbahnen (3) und Anordnen dieser Leiterbahnen (3) auf dem Plattengrundkörper (2);
c) Festlegen der Leiterbahnen (3) an dem Plattengrundkörper (2);
d) Ausrichten der Kontaktierstellen (5) und Bestücken der Kontaktierstellen mit den elektrischen und/oder elektronischen Bauelementen (4) und
e) Ausstanzen von Trennstellen (9) der Leiterbahnen (3).

## Beschreibung

Die Erfindung betrifft ein Verfahren zur Herstellung elektrischer Schaltungen mit einer Leiterplatte und auf einem Plattengrundkörper befestigten Leiterbahnen mit mindestens einer Kontaktierstelle zur Aufnahme mindestens eines elektrischen und/oder elektronischen Bauelementes.

Bei den aus der Praxis bekannten gattungsbildenden Leiterplatten werden die Leiterbahnen über Befestigungslaschen an dem Plattengrundkörper befestigt, wobei die Befestigungslaschen durch vorgestanzte Öffnungen des Plattengrundkörpers hindurchgesteckt und auf der Unterseite des Plattengrundkörpers umgebogen werden. Zur Bestückung der Leiterbahnen mit elektrischen und/oder elektronischen Bauelementen, wie beispielsweise Widerständen, Kondensatoren, Dioden, Thermoschaltern, Thermosicherungen und dergleichen werden diese Bauelemente an den Kontaktierstellen der Leiterbahnen mit den Leiterbahnen verlötet oder punktverschweißt. Ein solches Befestigen der Leiterbahnen auf dem Plattengrundkörper sowie das Bestücken der Leiterbahnen mit den elektrischen und/oder elektronischen Bauelementen ist zwar teilweise automatisierbar, jedoch ist das Befestigen der einzelnen Leiterbahnen auf dem Plattengrundkörper sowie das Verlöten bzw. Verschweißen der elektrischen und/oder elektronischen Bauelemente mit den Leiterbahnen sehr zeitaufwendig und folglich mit hohen Produktionskosten verbunden.

Der Erfindung liegt in Anbetracht dieses Standes der Technik die **Aufgabe** zugrunde, ein Verfahren der eingangs genannten Art derart zu verbessern, daß die Befestigung der Leiterbahnen auf dem Plattengrundkörper sowie die Bestückung der Leiterbahnen mit den elektrischen und/oder elektronischen Bauelementen vollautomatisch und somit kostengünstig erfolgen kann.

Die erfindungsgemäße **Lösung** dieser Aufgabe ist gekennzeichnet durch die Verfahrensschritte:
a) Ausstanzen der einstückigen Leiterbahnen aus einem ebenen Blechstanzteil, wobei die einzelnen Leiterbahnen ein zusammenhängendes Band bildend über einen schmalen Rahmen miteinander verbunden sind und die Kontaktierstellen als Klemmverbindungen in der Form von Schneidklemmverbindungen und/oder Gabelfederverbindungen ausgebildet sind;
b) Ausstanzen der einzelnen einstückigen Leiterbahnen und Anordnen dieser Leiterbahnen auf dem Plattengrundkörper;
c) Festlegen der Leiterbahnen an dem Plattengrundkörper;
d) Ausrichten der Kontaktierstellen und Bestücken der Kontaktierstellen mit den elektrischen und/oder elektronischen Bauelementen und
e) Ausstanzen von Trennstellen der Leiterbahnen.

Anstelle der bisher bekannten Löt- oder Schweißverbindung zum Bestücken der Leiterbahnen mit den elektrischen und/oder elektronischen Bauelementen wird bei der erfindungsgemäß ausgestalteten Leiterplatte erstmalig vorgeschlagen, daß die mindestens eine Kontaktierstelle als Klemmverbindung ausgebildet ist und somit auf einfache Weise und ohne Zuhilfenahme eines Zusatzwerkstoffes die Leiterbahn mit den entsprechenden Bauelementen bestückt werden können. Weiter ist vorteilhaft, daß durch die Klemmverbindung auf jeden Fall ein ausreichender Kontakt zwischen dem anzubringenden Bauelement und der Kontaktierstelle entsteht, wohingegen es bei der aus dem Stand der Technik bekannten Verlötung zu sogenannten "kalten Lötstellen" kommen kann, an denen kein ausreichender Kontakt vorliegt.

Die Klemmverbindung ist dabei vorteilhafterweise als Schneidklemmverbindung oder Gabelfederverbindung ausgebildet. Diese aus dem Gebiet der elektrischen Steckverbindungen an sich bekannten Verbindungstechniken gewährleisten eine leichte, schnelle und zuverlässige Kontaktierung zwischen den elektrischen und/oder elektronischen Bauelementen und den Leiterbahnen. Die notwendigen Trennstellen zwischen einzelnen Leiterbahnen sind nach dem Befestigen der Leiterbahnen auf dem Plattengrundkörper ausstanzbar. Zu diesem Zweck weist der Plattengrundkörper an den Stellen der Trennstellen Ausnehmungen auf, so daß die zum Trennen der einzelnen Leiterbahnen notwendigen Trennstellen durch einfaches Ausstanzen aus dem Blechteil hergestellt werden können, ohne daß dadurch der Plattengrundkörper beschädigt wird.

Um auch das Befestigen der Leiterbahnen auf dem Plattengrundkörper möglichst schnell und vollautomatisch durchführen zu können, sind die Leiterbahnen einstückig aus einem Blechteil gestanzt.

Die einstückig ausgestanzten Leiterbahnen sind gemäß einer bevorzugten Ausführungsform der Erfindung an dem Plattengrundkörper angenietet. Durch die einstückige Ausgestaltung der Leiterbahnen wird gewährleistet, daß die einzelnen Abschnitte der Leiterbahnen in der richtigen Ausrichtung zueinander auf dem Plattengrundkörper angeordnet sind.

Gemäß einer weiteren Ausführungsform des erfindungsgemäßen Verfahrens erfolgt das Festlegen der Leiterbahnen an dem Plattengrundkörper über an den Leiterbahnen angeformte Laschen, die durch entsprechende Öffnungen des Plattengrundkörpers gesteckt und auf der Rückseite umgelegt werden. Auf diese Weise kann das Festlegen der Leiterbahnen ohne ein zusätzliches, das heißt separates Bauteil erfolgen.

Weitere Einzelheiten, Merkmale und Vorteile des Gegenstandes der Erfindung ergeben sich aus der nachfolgenden Beschreibung der zugehörigen Zeichnungen, in denen eine Ausführungsform einer erfindungsgemäßen Leiterplatte dargestellt ist. In den Zeichnungen zeigt:
- Fig. 1: eine Draufsicht auf eine vollständig bestückte Leiterplatte und
- Fig. 2: eine Draufsicht auf einen Teil der Leiterbahnen vor der Befestigung auf dem Plattengrundkörper.

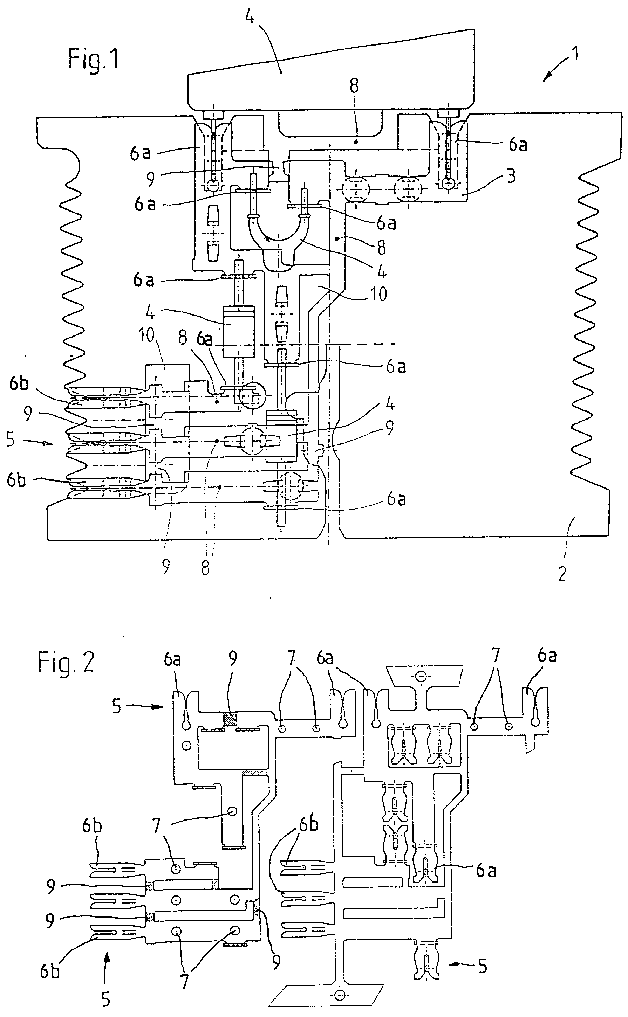

Die in Fig. 1 dargestellte Leiterplatte 1 besteht im wesentlichen aus einem ebenen Plattengrundkörper 2, auf diesem Plattengrundkörper 2 angeordneten Leiterbahnen 3 sowie elektrischen bzw. elektronischen Bauelementen 4, welche an Kontaktierstellen 5 mit den Leiterbahnen 3 verbunden sind.

Wie aus Fig. 2 ersichtlich, bestehen die Leiterbahnen 3 aus einem ebenen Blechstanzteil. Die Kontaktierstellen 5 sind bei dem dargestellten Ausführungsbeispiel als Schneidklemmverbindungen 6a und Gabelfederverbindungen 6b ausgebildet, die nach dem Verbinden der Leiterbahnen 3 mit dem Plattengrundkörper 2 zur Aufnahme der Bauelemente 4 hochgebogen werden können, wie dies in Fig. 1 dargestellt ist. Zur Befestigung der Leiterbahnen 3 an dem Plattengrundkörper 2 werden bei dieser Ausführungsform beim Stanzen der Leiterbahnen 3 Nietlöcher 7 vorgesehen, über die mittels Nietverbindungen 8 die notwendige Verbindung zwischen den Bauteilen 2 und 3 bewirkt wird.

Eine solchermaßen ausgestaltete Leiterplatte 1 zeichnet sich dadurch aus, daß einerseits die Leiterbahnen 3 als ebenes, einstückiges Blechstanzteil ausgebildet sind und andererseits die Kontaktierstellen 5 zur Aufnahme der elektrischen bzw. elektronischen Bauelemente 4 als Schneidklemmverbindungen 6a und Gabelfederverbindungen 6b ausgebildet sind, an denen die Bauteile 4 durch einfaches Eindrücken zu befestigen sind. Die Bestückung einer solchen Leiterplatte 1 kann vollautomatisch wie folgt durchgeführt werden:

In einem ersten Arbeitsschritt werden die Leiterbahnen 3 einstückig so aus einem Blechteil ausgestanzt, daß sie noch von einem schmalen Rahmen gehalten auf eine Rolle aufgerollt werden können. So aufgerollt können die Leiterbahnen 3 beim Kunden vollautomatisch aus dem Rahmen ausgestanzt und einem Plattengrundkörper 2 zugeteilt werden. Daraufhin werden die Leiterbahnen 3 beispielsweise über die Nietverbindungen 8 mit dem Plattengrundkörper 2 verbunden und die Kontaktierstellen 5 in die erforderlichen Stellungen umgebogen. In einem nachfolgenden, ebenfalls vollautomatisch durchführbaren Arbeitsschritt werden die elektrischen bzw. elektronischen Bauelemente 4 in die Schneidklemmverbindungen 6a und Gabelfederverbindungen 6b der Kontaktierstellen 5 eingeschoben. Als abschließender Arbeitsschritt werden Trennstellen 9 an den Stellen der Leiterbahnen 3 ausgestanzt, an denen keine elektrische Verbindung zwischen den einzelnen Leiterbahnen 3 bzw. Bauelementen 4 auftreten darf. Um dieses Ausstanzen der Trennstelle 9 zu erleichtern, weist der Plattengrundkörper 2 im Bereich der Trennstellen 9 Ausnehmungen 10 auf. Eine solchermaßen ausgestaltete Leiterplatte 1 kann somit von der Herstellung der Leiterbahnen 3 bis zur Bestückung der Leiterbahnen 3 mit den Bauelementen 4 vollautomatisch bearbeitet werden.

### Bezugszeichenliste

- 1: Leiterplatte
- 2: Plattengrundkörper
- 3: Leiterbahn
- 4: Bauelement
- 5: Kontaktierstelle
- 6a: Schneidklemmverbindung
- 6b: Gabelfederverbindung
- 7: Nietloch
- 8: Nietverbindung
- 9: Trennstelle
- 10: Ausnehmung

## Patentansprüche

1. Verfahren zur Herstellung elektrischer Schaltungen mit einer Leiterplatte und auf einem Plattengrundkörper befestigten Leiterbahnen mit mindestens einer Kontaktierstelle zur Aufnahme mindestens eines elektrischen und/oder elektronischen Bauelementes,
**gekennzeichnet durch**
die Verfahrensschritte:
a) Ausstanzen der einstückigen Leiterbahnen aus einem ebenen Blechstanzteil, wobei die einzelnen Leiterbahnen ein zusammenhängendes Band bildend über einen schmalen Rahmen miteinander verbunden sind und die Kontaktierstellen als Klemmverbindungen in der Form von Schneidklemmverbindungen und/oder Gabelfederverbindungen ausgebildet sind;
b) Ausstanzen der einzelnen einstückigen Leiterbahnen und Anordnen dieser Leiterbahnen auf dem Plattengrundkörper;
c) Festlegen der Leiterbahnen an dem Plattengrundkörper;
d) Ausrichten der Kontaktierstellen und Bestücken der Kontaktierstellen mit den elektrischen und/oder elektronischen Bauelementen und
e) Ausstanzen von Trennstellen der Leiterbahnen.

2. Verfahren nach Anspruch 1, dadurch gekennzeichnet, daß die Leiterbahnen an dem Plattengrundkörper angenietet werden.

3. Verfahren nach Anspruch 1, dadurch gekennzeichnet, daß zum Festlegen der Leiterbahnen an dem Plattengrundkörper an den Leiterbahnen angeformte Laschen durch entsprechende Öffnungen des Plattengrundkörpers gesteckt und auf der Rückseite umgelegt werden.
